Europäisches Patentamt

European Patent Office

Office européen des brevets

(11) Numéro de publication: **0 300 864 B1**

## (12) FASCICULE DE BREVET EUROPEEN

(45) Date de publication de fascicule du brevet: **09.06.93**

(51) Int. Cl.5: **G01R 31/28**, G01R 27/26, G07F 7/12

(21) Numéro de dépôt: **88401721.1**

(22) Date de dépôt: **01.07.88**

(54) **Dispositif de détection de la dépassivation d'un circuit intégré.**

(30) Priorité: **10.07.87 FR 8709792**

(43) Date de publication de la demande:
**25.01.89 Bulletin 89/04**

(45) Mention de la délivrance du brevet:
**09.06.93 Bulletin 93/23**

(84) Etats contractants désignés:
**DE ES GB IT NL**

(56) Documents cités:
**EP-A- 0 169 941**
**EP-A- 0 221 351**
**DE-A- 3 123 023**
**FR-A- 2 164 316**
**US-A- 3 750 018**

**IBM TECHNICAL DISCLOSURE BULLETIN, vol. 30, no. 1, juin 1987, pages 298-299, Armonk, New York, US; "Chip wiring capacitance measurement"**

(73) Titulaire: **SGS-THOMSON MICROELECTRO-NICS S.A.**
**7, Avenue Galliéni**
**F-94250 Gentilly(FR)**

(72) Inventeur: **Kowalski, Jacek**
**CABINET BALLOT-SCHMIT 84, Avenue Kléber**
**F-75116 Paris(FR)**

(74) Mandataire: **Ballot, Paul Denis Jacques et al**
**Cabinet Ballot-Schmit, 7, rue le Sueur**
**F-75116 Paris (FR)**

## Description

La présente invention a pour objet un dispositif de détection de la dépassivation d'un circuit intégré. Elle concerne, dans les domaines des semi-conducteurs, plus particulièrement celui des cartes bancaires où des circuits intégrés électroniques sont utilisés pour tenir à jour des soldes de comptes bancaires individuels d'une part, et/ou pour servir de clé d'accès d'autre part, par un code secret enregistré, à des machines bancaires (par exemple des distributeurs automatiques de billets de banque).

Un des problèmes les plus importants rencontrés pour les circuits intégrés mis en place sur des cartes bancaires est représenté par les risques de fraude. En effet, du fait de la confiance accordée à ce nouveau moyen financier de transaction, leur inviolabilité doit être assurée quelles que soient les circonstances. Ainsi on a par exemple inventé des systèmes qui empêchent de se servir du circuit d'alimentation en tension continue d'une carte bancaire munie d'un tel circuit intégré pour tenter de déceler les codes secrets que ces cartes peuvent contenir. Dans ce but on a rendu la tension, utilisable à l'intérieur du circuit intégré pour le polariser, indépendante de la tension d'alimentation. On a par ailleurs modifié les circuits de sortie de ces circuits intégrés de manière à ce que cette alimentation ne débite pas de courant différent selon que les états logiques lus dans la mémoire du circuit intégré et transmis sont des états logiques un ou des états logiques zéro. Dans un autre ordre d'idée on a modifié l'architecture de bornes de contact utilisables pour la programmation de ces circuits intégrés de manière à ce que, après cette programmation, toute action sur ces bornes soit sans effet. Mais l'imagination des fraudeurs n'a pas de limite.

On s'est rendu compte en effet qu'il était possible de connaître et de comprendre par déduction le fonctionnement d'un circuit intégré lorsque la couche de passivation qui recouvre ce circuit à l'issue de sa fabrication a été enlevée, et lorsqu'on sélectionne des points mémoire de sa mémoire tout en observant avec un microscope électronique le passage du courant dans les connexions de ce circuit intégré. Un tel problème est par exemple décrit dans le document EP-A-0 169 941. Pour remédier à ce problème, le document EP-A-0 169 941 décrit un dispositif de détection de la dépassivation comportant un circuit pour détecter la coupure d'une ligne résultant de cette dépassivation. La ligne se trouve au-dessus de la passivation.

Bien que ce moyen de fraude soit très coûteux, le protection contre cette fraude devient une nécessité.

L'invention a pour objet de remédier à ce problème particulier de fraude. Pour le résoudre on utilise le fait que la capacité présenté par une ligne, une connexion de ce circuit intégré, par rapport à une autre ligne de ce circuit intégré ou par rapport à une masse générale est modifiée par l'enlèvement de cette couche de passivation. En effet cette capacité de ligne est beaucoup plus importante si la passivation existe, par contre elle est plus faible quand celle-ci a été enlevée. Partant de cette remarque, dans l'invention, on branche aux bornes d'une telle capacité un détecteur comportant un seuil critique de déclenchement, intermédiaire entre des états électriques qu'est susceptible de prendre la ligne considérée avant et après opération de dépassivation. On peut utiliser des lignes spécifiquement réalisées dans ce but. On peut aussi utiliser des lignes déjà existantes dans le plan du circuit intégré: des lignes du plan mémoire par exemple. On peut par ailleurs, puisque le détecteur de dépassivation peut être très petit (il comporte dans un exemple six transistors), placer un certain nombre de ces détecteurs en de multiples endroits du circuit intégré de manière à interdire la neutralisation de ces détecteurs par une électrode approchée de l'extérieur. Si le nombre de ces détecteurs est trop grand, le nombre des électrodes de neutralisation sera trop grand, et il masquera le champ du microscope électronique.

L'invention concerne donc un dispositif de détection de la dépassivation d'un circuit intégré caractérisé en ce qu'il comporte des moyens (1-5) pour détecter une variation d'une capacité (Cab) de ligne résultant de cette dépassivation.

L'invention sera mieux comprise à la lecture de la description qui suit, et à l'examen des figures qui l'accompagnent. Celles-ci ne sont données qu'à titre indicatif et nullement limitatif de l'invention. Les figures montrent:
- figure 1: un exemple d'un dispositif de détection de dépassivation conforme à l'invention;
- figure 2: une forme particulière de lignes spécifiques utilisées dans ce dispositif de détection.

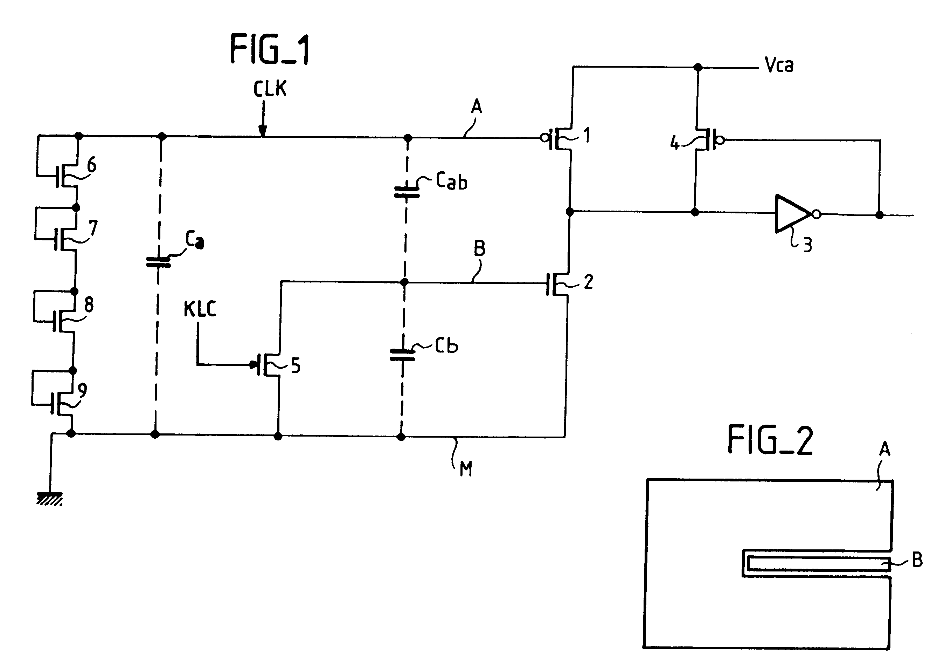

La figure 1 représente un dispositif de détection de la dépassivation conforme à l'invention. Ce dispositif comporte deux lignes, de préférence métallisées, les lignes A et B. Ces lignes présentent chacune par rapport à une masse générale M des capacités résultant de leur opposition physique respectivement Ca et Cb. Les lignes A et B présentent de plus entre elles une capacité Cab résultant de leur proximité l'une de l'autre. Si l'on applique un signal, par exemple un échelon de tension, sur une des lignes, la ligne A, ce signal se transmet par l'intermédiaire des capacités Cab et Cb sur la ligne B. Les capacités Cab et Cb forment ici un pont diviseur capacitif. Ce pont alimente la ligne B qui autrement peut être considérée comme électriquement en l'air. Si Va est la hauteur de l'échelon de tension, la valeur de la tension induite sur la ligne B vaut

Vb = Va. Cab / (Cab + Cb).

Lorsque la passivation est présente, la capacité Cab vaut Cab1 et la tension Vb devient Vb1 telle que :

Vb1 = Va. Cab1 / (Cab1 + Cb).

Par contre, sans la passivation Cab vaut Cab2 et cette tension devient Vb2 telle que :

Vb2 = Va. Cab2 / (Cab2 + Cb).

En posant que Cb est égal à k.Cab2 et que Cab1 est égal à n.Cab2 on peut écrire que la variation DVb de Vb entre un état et l'autre peut s'écrire :

DVb = Va.k (n - 1) / (n + k)(1 + k).

Pour que le détecteur fonctionne bien, il est nécéssaire d'obtenir DVb le plus important possible. Une étude mathématique montre que dans ce cas le coefficient k doit être le plus petit possible et que le coefficient n doit être le plus grand possible. Le coefficient k dépend principalement du dessin électrique des connexions (figure 2) et il est fixé de façon à avoir une tension Vb1 supérieure à un seuil, même pour un pire cas (tension de l'échelon faible : par exemple seulement 4 volts) quand le circuit est encore passivé. Au mieux le coefficient k peut être égal environ à 3. Dans la pratique, compte tenu de la dispersion de fabrication on choisit un coefficient k plus grand. Le coefficient n quant à lui dépend principalement de la constante dielectrique de la couche de passivation. Mais pratiquement n, qu'on souhaite le plus important possible, sera toujours pris inférieur à 3.

On peut calculer, dans un exemple numérique avec k = 10 et n = 2,5, ce qu'il advient des tensions Vb1 et Vb2, respectivement avant et après dépassivation. Le calcul est fait à chaque fois dans un pire cas c'est à dire quand la valeur de l'échelon de tension est faible (4 volts) dans le premier cas, et quand cette valeur de l'échelon est forte (6 volts) dans le deuxième cas respectivement. Les valeurs de ces tensions sont avec cet exemple respectivement Vb1 = 0,8 Volts et Vb2 = 0,55 volts. Cette différence peut être détectée par un circuit de détection comportant essentiellement un comparateur. Il peut y avoir une multitude de solutions.

Une des plus simples est représentée sur la figure 1. Le circuit de détection comporte un transistor 1 à canal P en série avec un transistor 2 à canal N entre l'alimentation électrique Vcc du circuit intégré et la masse M. Les lignes A et B sont respectivement connectées aux grilles des transistors 1 et 2. Un inverseur 3 branché au point milieu des transistors 1 et 2 inverse le signal disponible à ce point millieu. Un transistor 4 à canal P est monté en contre réaction sur cet inverseur entre l'entrée de cet inverseur et la tension d'alimentation Vcc. Le circuit 3-4 est un circuit bistable. De préférence l'échelon de tension CLK appliqué sur la ligne A est appliqué en même temps qu'un échelon de polarité complémentaire KLC sur la grile d'un transistor 5 à canal N monté en parallèle entre la ligne B et la masse M. Lorsque CLK vaut zero le transistor 5 rendu conducteur par KLC force à zéro la tension sur la ligne B. Le transistor 1 est alors conducteur et le transistor 2 est alors bloqué de sorte qu'un signal zéro est disponible à la sortie de l'inverseur 3. Lorsque l'échelon de tension est appliqué, le signal CLK passe à un et le signal KLC passe à zéro. le transistor 5 passe à l'état bloqué tandis que la tension Vb est induite sur la ligne B.

Si la passivation est encore présente la tension Vb devient Vb1 (dans un exemple 0,8 volts). Cette tension est supérieure au seuil de conduction du transistor 2, de sorte que ce transistor conduit et force l'entrée de l'inverseur 3 à zéro. En conséquence le circuit bistable 3-4 change de polarité : sa sortie passe à un. Par contre si la passivation a été enlevée la tension Vb2 (0,55 volts) est inférieure au seuil de conduction du transistor 2 : celui-ci reste bloqué tandis que le transistor 1, qui reçoit un échelon positif sur sa grille, se bloque. Le point milieu des deux transistors 1 et 2, qui n'est pas forcé à un potentiel particulier, est alors maintenu dans son état précédent par le circuit bistable 3-4. La sortie de l'inverseur 3 reste à zéro. Elle ne change donc pas d'état. On remarque alors que l'exploitation la plus simple du détecteur de l'invention consiste à faire transiter un signal d'horloge CLK par le circuit de détection de dépassivation. Si la passivation est encore présente au dessus du circuit, le signal d'horloge est transmis, si elle est absente ce signal d'horloge est étouffé.

On a évoqué ci-dessus les pires cas résultant d'une alimentation défectueuse du circuit intégré que l'on cherche à protéger. En particulier si l'alimentation électrique est trop forte au moment de la dépassivation, la tension induite sur la ligne B peut être proportionnellemnt trop forte et être suffisante pour déclencher le transistor 2. On limite cependant cette tension en mettant en parallèle entre la ligne A et la masse M un certain nombre de diodes telles que 6 à 9 en série. L'addition des seuils de conduction de ces diodes limite la tension imposable sur la ligne A. Dans ce cas la détection de la dépassivation est indépendante de la valeur de Vcc.

La figure 2 représente un mode préféré de réalisation des lignes A et B spécifiques à implanter dans le circuit intégré. Pour augmenter le coefficient k, favorable à une augmentation de DVb, la ligne métallisée B doit être entourée par la ligne métallisée A. Dans ce même but, on augmente au maximum la surface de la ligne A et on ménage un écart minimal entre les deux lignes.

**Revendications**

1. Dispositif de détection de la dépassivation d'un circuit intégré caractérisé en ce qu'il comporte des moyens (1-5) pour détecter une variation d'une capacité (Cab) de ligne résultant de cette dépassivation.

2. Dispositif selon la revendication 1 caractérisé en ce que les moyens pour détecter comportent deux lignes (A,B) mutuellement couplées (Cab) capacitivement par la passivation et un circuit de masse couplé (Ca, Cb) capacitivement à au moins une des lignes par mise en opposition avec cette ligne, la capacité de passivation constituant la capacité d'opposition d'un pont diviseur capacitif établi entre ces deux lignes et la masse (M).

3. Dispositif selon la revendication 2 caractérisé en ce que les moyens pour détecter comportent un comparateur (2) bistable connecté au point milieu du pont diviseur.

4. Dispositif selon l'une quelconque des revendications 2 ou 3 caractérisé en ce qu'une (A) des deux lignes entoure l'autre (B).

5. Dispositif selon l'une quelconque des revendications 2 à 4 caractérisé en ce qu'une des deux lignes est raccordée à la masse par un circuit écrêteur (6-9).

6. Dispositif selon la revendication 5 caractérisé en ce que le circuit écrêteur (6-9) comporte un ensemble de diodes en série.

7. Dispositif selon l'une quelconque des revendications 1 à 6 caractérisé en ce que la ligne est métallisée.

8. Dispositif selon l'une quelconque des revendications 1 à 7 caractérisé en ce qu'il est mis en série avec les lignes de transmission d'un signal (CLK) d'horloge à ce circuit intégré.

9. Circuit intégré muni de plusieurs détecteurs selon l'une quelconque des revendications 1 à 8.

**Claims**

1. Apparatus for detecting depassivation of an integrated circuit, characterised in that it includes means (1 to 5) for detecting a variation in a line capacity ($C_{ab}$) resulting from the said depassivation.

2. Apparatus according to Claim 1, characterised in that the detecting means comprise two lines (A, B) coupled capacitively together ($C_{ab}$) by the passivation, and an earth circuit coupled capacitively ($C_a$, $C_b$) to at least one of the lines by being placed in opposed relationship with the said line, the passivation capacity constituting the opposition capacity of a capacitive divider bridge established between the two said lines and earth (N).

3. Apparatus according to Claim 2, characterised in that the detecting means comprise a bistable comparator (2) connected to the midpoint of the divider bridge.

4. Apparatus according to either one of Claims 2 and 3, characterised in that one of the two lines (A) surrounds the other (B).

5. Apparatus according to any one of Claims 2 to 4, characterised in that one of the two lines is connected to earth through a limiting circuit (6 to 9).

6. Apparatus according to Claim 5, characterised in that the limiting circuit (6 to 9) comprises a set of diodes connected in series.

7. Apparatus according to any one of Claims 1 to 6, characterised in that the line is metallised.

8. Apparatus according to any one of Claims 1 to 7, characterised in that it is put in series with the transmission lines for transmitting a clock signal (CLK) to the said integrated circuit.

9. An integrated circuit having a plurality of detectors in accordance with any one of Claims 1 to 8.

**Patentansprüche**

1. Vorrichtung zur Detektion der Entpassivierung einer integrierten Schaltung, dadurch **gekennzeichnet,** daß sie Mittel (1-5) zur Detektion einer Änderung einer Leitungskapazität (Cab) umfaßt, die aus dieser Entpassivierung resultiert.

**2.** Vorrichtung nach Anspruch 1, dadurch **gekennzeichnet,** daß die Mittel zur Detektion zwei durch die Passivierung wechselseitig kapazitiv gekoppelte (Cab) Leitungen (A, B) und einen Massekreis (Ca, Cb) umfassen, der kapazitiv mit wenigstens einer der Leitungen durch Anordnung im Gegensatz zu dieser Leitung gekoppelt ist, wobei die Passivierungskapazität die Gegenkapazität einer kapazitiven Teilerbrücke bildet, die zwischen den beiden Leitungen und Masse (M) vorgesehen ist.

**3.** Vorrichtung nach Anspruch 2, dadurch **gekennzeichnet,** daß die Mittel zur Detektion einen bistabilen Komparator (2) umfassen, der mit dem Mittelpunkt der Teilerbrücke verbunden ist.

**4.** Vorrichtung nach einem beliebigen der Ansprüche 2 oder 3, dadurch **gekennzeichnet,** daß eine (A) der beiden Leitungen die andere (B) umgibt.

**5.** Vorrichtung nach einem beliebigen der Ansprüche 2 bis 4, dadurch **gekennzeichnet,** daß eine der beiden Leitungen durch einen Begrenzerkreis (6-9) mit Masse verbunden ist.

**6.** Vorrichtung nach Anspruch 5, dadurch **gekennzeichnet,** daß der Begrenzerkreis (6-9) einen Satz von Dioden in Reihe umfaßt.

**7.** Vorrichtung nach einem beliebigen der Ansprüche 1 bis 6, dadurch **gekennzeichnet,** daß die Leitung metallisiert ist.

**8.** Vorrichtung nach einem beliebigen der Ansprüche 1 bis 7, dadurch **gekennzeichnet,** daß sie in Reihe mit den Leitungen zur Übertragung eines Taktsignals (CLK) zu dem integrierten Schaltkreis angeordnet ist.

**9.** Integrierter Schaltkreis, versehen mit mehreren Detektoren gemäß einem beliebigen der Ansprüche 1 bis 8.

FIG_1

FIG_2

EP 0 300 864 B1